# FASCICULE DE BREVET EUROPEEN

(11) **EP 0 833 419 B1**
(45) Date de publication et mention de la délivrance du brevet: **14.11.2001**
(21) Numéro de dépôt: 97402227.9
(22) Date de dépôt: 25.09.1997
(51) Int. Cl.: H01S 5/40, H01S 5/024

(54) **Dispositif à diodes laser semiconductrices et son procédé de réalisation**
Laserdiodenanordnung und Herstellungsverfahren
Laser diode assembly and method of fabrication

(30) Priorité: 30.09.1996 RU 96119588
(43) Date de publication de la demande: 01.04.1998
(73) Titulaire: COMPAGNIE INDUSTRIELLE DES LASERS CILAS, F-91460 Marcoussis (FR)
(72) Inventeur: Apollonov, Viktor Viktorovitch, 117333 Moscou (RU); Babaiants, Guennadi Ivanovitch, 142100 Podolsk, Moucou (RU); Derjavine, Serguei Igorevitch, 125502 Moscou (RU); Kichmakhov, Batori Chakhimovitch, 142117 Podolsk, Moscou (RU); Koval, Youri Pétrovitch, 140070 Tomilino Moscou (RU); Kouzminov, Vitali Vladimirovitch, 129278 Moscou (RU); Machkovski, Dmitri Aleksandrovitsch, 117463 Moscou (RU); Prokhorov, Aleksandr Mikhailovitch, 117831 Moscou (RU); Smekaline, Viktor Pavlovitch, 113535 Moscou (RU); Cornillault, Jean, 91620 Nozay (FR); Foucher, Thierry Jean Daniel Xavier, 91120 Palaiseau (FR)
(74) Mandataire: Bonnetat, Christian

(56) Documents cités:
- EP-A- 0 687 047
- US-A- 5 128 951
- BEACH R ET AL: "MODULAR MICROCHANNEL COOLED HEATSINKS FOR HIGH AVERAGE POWER LASER DIODE ARRAYS" IEEE JOURNAL OF QUANTUM ELECTRONICS, vol. 28, no. 4, 1 avril 1992, pages 966-976, XP000272687
- PATENT ABSTRACTS OF JAPAN vol. 015, no. 054 (E-1031), 8 février 1991 -& JP 02 281781 A (MATSUSHITA ELECTRIC IND CO LTD), 19 novembre 1990,

## Description

La présente invention a pour objet les dispositifs laser à diodes laser semi-conductrices et, en particulier, de tels dispositifs à matrice de diodes laser. Elle concerne également un procédé de réalisation de tels dispositifs laser.

Par exemple par le brevet américain US-A-5 128 951, on connaît déjà un dispositif laser à diodes comportant :
- une pluralité de parois parallèles et espacées, en une matière bonne conductrice de la chaleur, qui ont des chants longitudinaux libres au moins approximativement coplanaires et portant des films d'une matière électriquement conductrice qui se prolongent de part et d'autre desdits chants sur les deux faces desdites parois ;
- une pluralité de barrettes semi-conductrices incorporant lesdites diodes laser et comprenant chacune une face émettrice par laquelle émettent les diodes laser de la barrette correspondante, lesdites barrettes semi-conductrices étant logées longitudinalement dans les espaces entre lesdites parois et chacune desdites barrettes semi-conductrices étant solidarisée des faces en regard des deux parois entre lesquelles elle est logée, de façon que lesdites barrettes semi-conductrices soient électriquement montées en série par lesdits films de matière électriquement conductrice et que les faces émettrices desdites barrettes semi-conductrices soient au moins approximativement coplanaires avec lesdits chants longitudinaux libres desdites parois ; et
- des moyens de refroidissement à circulation de fluide destinés à refroidir lesdites barrettes de diodes.

Les dispositifs laser connus de ce type comportent un bloc de matière bonne conductrice de la chaleur qui est porté par lesdits moyens de refroidissement à circulation de fluide. Dans ledit bloc sont pratiquées, mécaniquement ou chimiquement, des rainures parallèles, formant les logements desdites barrettes de diodes et délimitant entre elles des nervures dont chacune d'elles forme une desdites parois sur lesquelles sont soudées lesdites barrettes de diode. Du côté opposé aux chants longitudinaux libres des nervures, celles-ci sont réunies par une semelle, qui correspond à la partie dudit bloc non entamée par lesdites rainures et par laquelle ledit bloc est relié auxdits moyens de refroidissement.

De tels dispositifs laser connus présentent de nombreux inconvénients.

Tout d'abord, l'évacuation de la chaleur engendrée par lesdites diodes n'est pas bonne. En effet, entre les barrettes de diodes et le fluide de refroidissement, la chaleur doit parcourir un long trajet qui passe à travers les soudures des barrettes sur les nervures, le long de la hauteur desdites nervures, à travers ladite semelle et, enfin, à travers la paroi desdits moyens de refroidissement qui porte ladite semelle. Par ailleurs, pour pouvoir loger aisément lesdites barrettes dans lesdites rainures, il est indispensable de prévoir des jeux compensés par la soudure. Par suite, les soudures entre les barrettes de diodes et les rainures sont plus épaisses que cela serait suffisant pour assurer le contact électrique, de sorte que la transmission de chaleur est freinée au niveau desdites soudures. Cet effet de frein de transmission de chaleur est amplifié du fait que la planéité et la rugosité des flancs des nervures ne peuvent être optimisées lors du creusage desdites rainures. Ces dispositifs laser connus ne peuvent donc assurer une grande densité de rayonnement, du fait de la trop faible évacuation de chaleur. Si on recherche une densité de rayonnement élevée, les diodes laser sont donc surchauffées et rapidement détruites.

Par ailleurs, du fait de l'existence obligatoire de jeux entre les barrettes de diodes et les nervures et de l'impossibilité d'appliquer une pression satisfaisante entre lesdites barrettes et lesdites nervures au moment du soudage, la continuité du contact électrique entre lesdites barrettes de diode peut être défectueuse, malgré - -ou à cause de-- l'épaisseur relativement importante desdites soudures.

En outre, l'usinage desdites rainures, la mise en place et le soudage desdites barrettes dans celles-ci exigent une précision très élevée, peu compatible avec une fabrication industrielle et des coûts de fabrication raisonnables.

La présente invention a pour objet de remédier à ces inconvénients. Elle concerne un dispositif laser du type rappelé ci-dessus, dans lequel l'évacuation de chaleur est améliorée, de sorte que l'homogénéité et la densité de rayonnement, ainsi que la durée de vie dudit dispositif laser, peuvent être élevées, la structure dudit dispositif laser perfectionné conformément à la présente invention permettant de plus de garantir une excellente continuité électrique entre les barrettes de diodes et de permettre une fabrication industrielle à faibles coûts.

A ces fins, selon l'invention, le dispositif laser à diodes du type mentionné ci-dessus est remarquable :
- en ce que lesdites parois parallèles et espacées sont formées par des plaquettes individuelles assemblées les unes aux autres avec interposition desdites barrettes semi-conductrices comme entretoises ;
- en ce que lesdites barrettes semi-conductrices n'occupent qu'une partie longitudinale des espaces entre plaquettes dans lesquels elles sont logées ; et
- en ce que les parties longitudinales desdits espaces entre plaquettes, non occupées par lesdites barrettes semi-conductrices, servent de canaux de circulation pour ledit fluide de refroidissement.

Ainsi, puisque le fluide de refroidissement est au contact direct desdites plaquettes, l'évacuation de la chaleur engendrée par les barrettes semi-conductrices est optimale. Par ailleurs, puisque lesdites plaquettes peuvent être préparées individuellement, il est possible de leur conférer une bonne planéité et une bonne rugosité (inférieure à 20 Angströms), de sorte que l'épaisseur des soudures avec les barrettes peut être minimale et que la transmission de chaleur au niveau de ces soudures peut être maximale. Les diodes desdites barrettes sont donc refroidies efficacement, de sorte qu'elles peuvent engendrer une densité de rayonnement élevée, sans surchauffer ni être détruites.

De préférence, pour réaliser le dispositif laser à diodes conforme à la présente invention, on opère de la façon suivante :
- on prépare une pluralité de plaquettes individuelles rectangulaires identiques en une matière bonne conductrice de la chaleur, on polit au moins leurs deux grandes faces et un de leurs chants longitudinaux et on recouvre lesdits chants longitudinaux polis et les zones latérales contiguës desdites grandes faces polies par des films d'une matière bonne conductrice de l'électricité ;
- on prépare une pluralité de barrettes de diodes semi-conductrices rectangulaires identiques, dont un chant longitudinal sert de face émettrice auxdites diodes et dont les deux grandes faces sont recouvertes de films de contact conducteurs de l'électricité ;
- on applique les films de contact desdites barrettes contre les zones latérales des films de matière électriquement conductrice desdites plaquettes, avec interposition de films de solidarisation électriquement conducteurs ; et
- on solidarise entre elles lesdites plaquettes et lesdites barrettes par action desdits films de solidarisation, avec application de pression.

Grâce à un tel procédé de réalisation, notamment à l'application d'une pression pendant la solidarisation des barrettes de diodes et des plaquettes thermiquement conductrices, on obtient des contacts électriques excellents entre les diodes. Par ailleurs, ce procédé élimine toutes les difficultés liées aux jeux précités et permet une fabrication industrielle à des coûts de fabrication relativement bas.

Les films de solidarisation pourraient être réalisés en une colle électriquement conductrice. Toutefois, dans un mode préféré de réalisation, ces films de solidarisation sont constitués par une soudure électriquement conductrice. De préférence, de tels films de soudure sont alors portés par lesdites zones latérales des films de matière électriquement conductrice desdites plaquettes.

Selon un premier mode de mise en oeuvre du procédé conforme à l'invention :
- on réalise un empilage de toutes lesdites plaquettes et de toutes lesdites barrettes, de façon que :
   . chaque barrette soit interposée entre deux plaquettes ;
   . les chants longitudinaux desdites plaquettes, recouverts d'un film de matière électriquement conductrice soient au moins approximativement coplanaires ;
   . les faces émettrices desdites barrettes de diodes soient au moins approximativement coplanaires avec lesdits chants longitudinaux desdites plaquettes ;
   . chaque film de contact d'une grande face d'une barrette soit superposé à un film de soudure d'une grande face d'une plaquette ; et
- on porte la totalité dudit empilage à une température correspondant à la température de fusion desdits films de soudure, tout en soumettant ledit empilage à une pression transversale auxdites plaquettes et barrettes, après quoi on laisse refroidir ledit empilage.

On réalise ainsi l'ensemble desdites plaquettes et desdites barrettes en une seule opération. Toutefois, l'outillage alors utilisé pour superposer et maintenir lesdites plaquettes et barrettes avec précision, doit être relativement compliqué.

Aussi, pour permettre de simplifier cet outillage, selon un second mode de mise en oeuvre du procédé conforme à la présente invention, on opère de la façon suivante :
- lors de la préparation desdites plaquettes, on recouvre l'un desdits films latéraux de matière conductrice de chaque plaquette, d'un film d'une première soudure électriquement conductrice ;
- on forme une pluralité de sous-ensembles, dont chacun d'eux comporte une plaquette et une barrette, en superposant à chaque fois une plaquette et une barrette de façon que le film de soudure de la plaquette soit superposé à un film de contact de la barrette et que le chant longitudinal de ladite plaquette soit au moins approximativement coplanaire avec la face émettrice de la barrette, puis en portant chaque sous-ensemble à une température correspondant à la température de fusion de ladite première soudure, tout en le soumettant à une pression transversale à ladite plaquette et à ladite barrette, après quoi on laisse refroidir ledit sous-ensemble ;
- dans chaque sous-ensemble, on recouvre l'autre desdits films latéraux de matière conductrice de la plaquette correspondante, d'un film d'une seconde soudure électriquement conductrice, ayant une température de fusion inférieure à celle de ladite première soudure ;
- on forme un empilage desdits sous-ensembles, en les superposant, à chaque fois, de façon que l'autre film de contact de la barrette d'un sous-ensemble soit appliqué contre le film de ladite seconde soudure de la plaquette d'un autre sous-ensemble et que les chants longitudinaux de toutes les plaquettes soient au moins approximativement coplanaires entre eux et avec les faces émettrices desdites barrettes ; et
- on porte ledit empilage de sous-ensembles à une température correspondant à la température de fusion de ladite seconde soudure, tout en soumettant ledit empilage à une pression transversale auxdites plaquettes et barrettes, après quoi on laisse refroidir ledit empilage de sous-ensembles.

On remarquera que ce second mode de mise en oeuvre du procédé conforme à l'invention permet de contrôler tous lesdits sous-ensembles avant leur assemblage.

De préférence, le dispositif à diodes laser semi-conductrices conforme à la présente invention comporte, dans les espaces entre plaquettes, des moyens d'étanchéité isolant lesdites barrettes dudit fluide de refroidissement.

Dans un mode de réalisation préféré, le dispositif conforme à la présente invention comporte un boîtier pourvu :
- d'un logement pour ledit agencement monopièce des plaquettes individuelles et des barrettes semi-conductrices ;
- des moyens d'amenée dudit fluide de refroidissement dans ledit logement ; et
- des moyens d'évacuation dudit fluide hors dudit logement.

Dans ce mode de réalisation, ledit fluide de refroidissement circule dans les parties longitudinales desdits espaces entre plaquettes, non occupés par lesdites barrettes, en traversant ledit logement du boîtier.

Avantageusement, afin d'assurer une circulation régulière de fluide de refroidissement entre lesdites plaquettes, ledit boîtier comporte un réservoir d'accumulation dudit fluide, d'une part entre lesdits moyens d'amenée et ledit logement et, d'autre part, entre ledit logement et lesdits moyens d'évacuation.

Les figures du dessin annexé feront bien comprendre comment l'invention peut être réalisée. Sur ces figures, des références identiques désignent des éléments semblables.

La figure 1 est une coupe horizontale, selon la ligne I-I de la figure 2, d'un exemple de réalisation du dispositif à diodes laser conforme à la présente invention.

La figure 2 est une coupe longitudinale dudit dispositif, selon la ligne brisée II-II de la figure 1.

La figure 3 est une coupe transversale dudit dispositif, selon la ligne III-III de la figure 1.

La figure 4 est une vue de dessus du boîtier du dispositif des figures 1 à 3.

La figure 5 est une coupe longitudinale dudit boîtier, selon la ligne brisée V-V de la figure 4.

La figure 6 est une coupe transversale dudit boîtier, selon la ligne VI-VI de la figure 4.

La figure 7 est une vue en coupe transversale agrandie de l'agencement monopièce des plaquettes individuelles et des barrettes semi-conductrices du dispositif conforme à la présente invention.

Les figures 8A et 8B illustrent schématiquement la préparation desdites barrettes semi-conductrice en vue de la réalisation dudit agencement monopièce.

Les figures 8C et 8D illustrent schématiquement la préparation desdites plaquettes individuelles en vue de la réalisation dudit agencement monopièce.

La figure 8E illustre schématiquement la solidarisation desdites plaquettes et desdites barrettes.

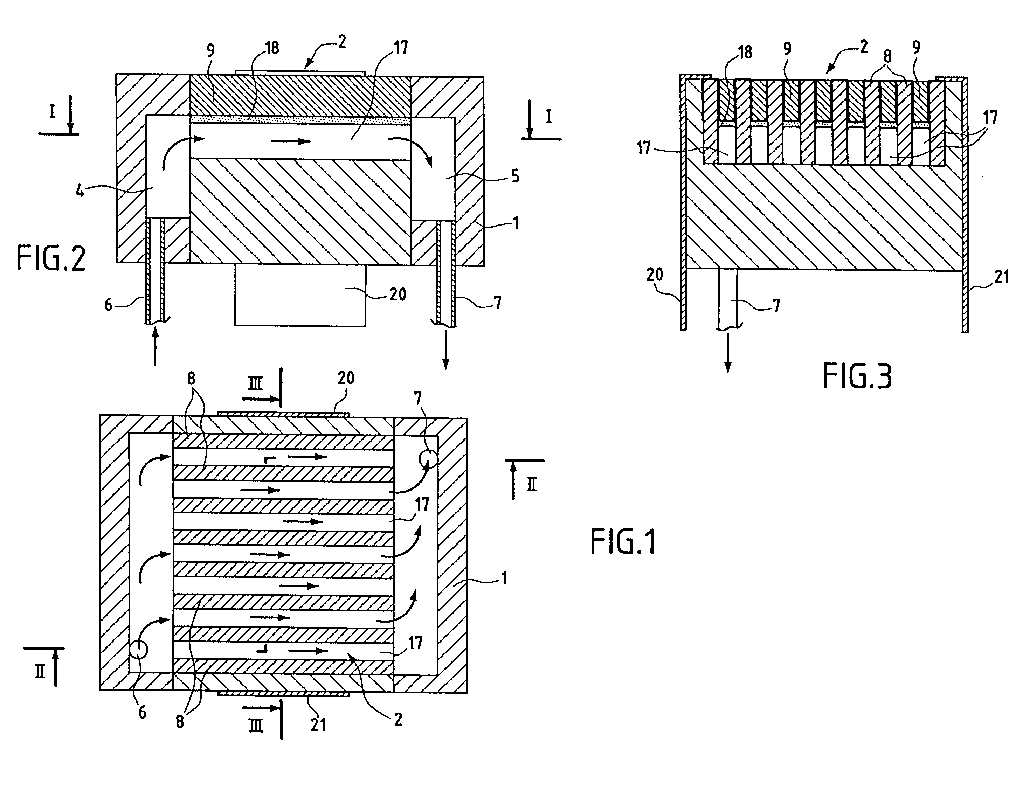

Le dispositif laser à diodes, conforme à la présente invention et représenté sur les figures 1 à 3, comporte un boîtier 1 et un agencement monopièce 2 de plaquettes en une matière bonne conductrice de la chaleur et de barrettes semi-conductrices à diodes laser.

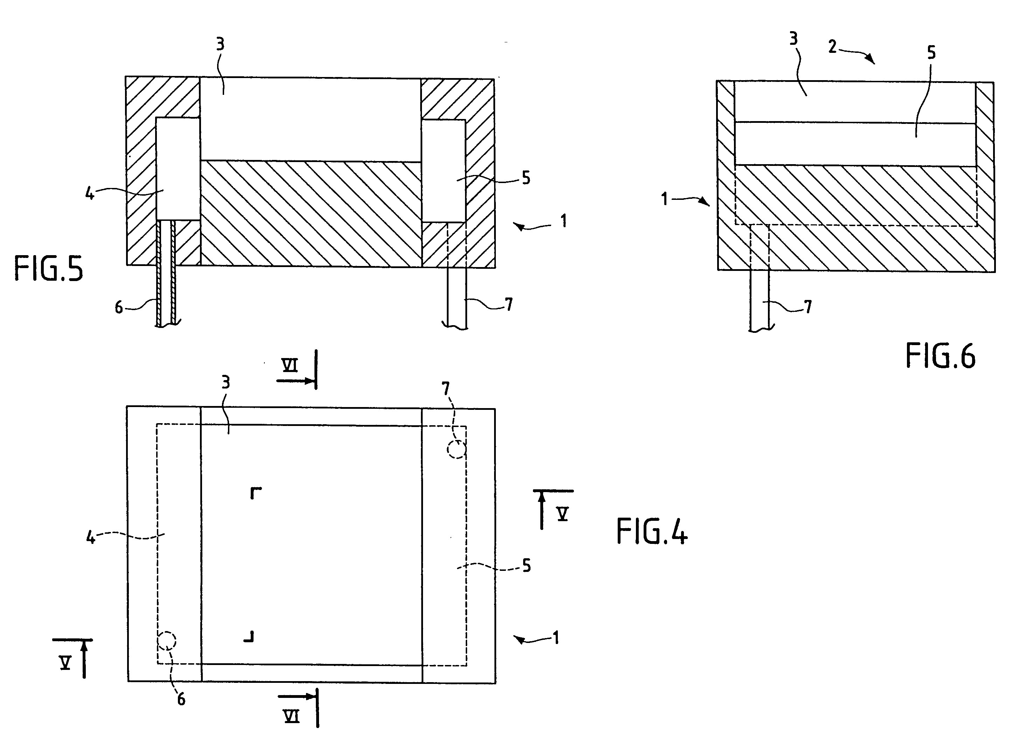

Dans l'exemple de réalisation représenté sur ces figures et sur les figures 4 à 6, le boîtier 1 est constitué de plusieurs pièces, par exemple en un métal comme l'aluminium ou le cuivre, assemblées les unes aux autres de manière étanche. Le boîtier 1 comporte un logement 3 dans lequel l'agencement 2 peut être introduit et fixé de façon étanche, par exemple par collage. De part et d'autre du logement 3, sont prévus des réservoirs 4 et 5, en communication avec celui-ci sur toute sa largeur. Dans les réservoirs 4 et 5 débouchent, respectivement, une conduite 6 d'amenée de fluide et une conduite 7 d'évacuation de fluide, lesdites conduites 6 et 7 étant disposées en diagonale l'une de l'autre par rapport au logement 3.

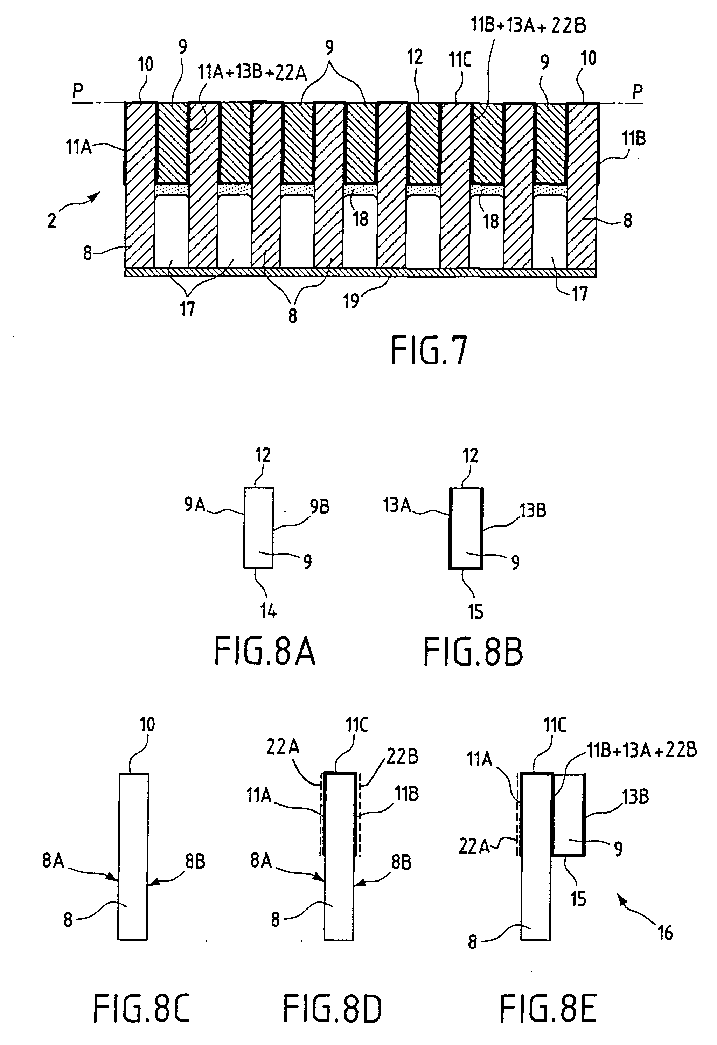

Comme le montre à plus grande échelle la figure 7, l'agencement 2 comporte une pluralité de plaquettes individuelles parallèles 8, assemblées les unes aux autres avec interposition, à chaque fois entre deux plaquettes consécutives, d'une barrette semi-conductrice 9 servant d'entretoise.

Les plaquettes individuelles 8 sont réalisées en un matériau à haute conductibilité thermique, comme par exemple l'oxyde de béryllium BeO, le carbure de silicium SiC, le diamant, etc ... Ce matériau pourrait également être un métal, mais il est avantageux qu'il ne soit pas conducteur de l'électricité, car alors, comme on le verra par la suite, on peut utiliser de l'eau comme fluide de refroidissement. Dans un exemple de réalisation particulier, les plaquettes individuelles 8 étaient toutes identiques et présentaient une forme parallélépipédique rectangulaire avec une longueur de 1 cm, une largeur de 0,3 cm et une épaisseur de 0,02 cm. Les chants longitudinaux libres (supérieurs) 10 des plaquettes individuelles 8 sont coplanaires, comme cela est illustré schématiquement sur la figure 7 par la trace d'un plan P-P. Au moins les parties des grandes faces 8A et 8B desdites plaquettes 8, voisines desdits chants longitudinaux 10, sont polies pour être rigoureusement planes et présenter une rugosité inférieure à 20 Angströms. Par ailleurs, comme cela est illustré sur la figure 8D, chaque plaquette individuelle 8 est revêtue, avant son incorporation dans l'agencement 2, d'un film 11 de matière électriquement conductrice comportant une partie 11C recouvrant son chant longitudinal 10 et des parties latérales 11A et 11B recouvrant partiellement en hauteur lesdites grandes faces 8A et 8B. Un tel film électriquement conducteur 11 peut par exemple être en molybdène ou en nickel, ou en un alliage de tels métaux et son épaisseur peut être comprise entre 50 et 200 microns. Comme cela est illustré sur la figure 8D, les parties latérales 11A et 11B dudit film 11 sont respectivement recouvertes d'un film 22A ou 22B de soudure électriquement conductrice, par exemple en un alliage de molybdène, de nickel et d'indium. Un tel film de soudure peut avoir une épaisseur au plus égale à 10 microns.

De façon connue, les barrettes semi-conductrices parallélépipédiques rectangulaires 9 peuvent être obtenues par découpage en bandes de substrats semiconducteurs dans lesquels lesdites diodes laser sont obtenues par épitaxie. Les barrettes 9 peuvent avoir une longueur de 1 cm, une largeur de 0,15 cm et une épaisseur de 0,02 cm.

Au moins les grandes faces 9A et 9B des barrettes semi-conductrices 9 sont polies pour être rigoureusement planes et présentent une rugosité inférieure à 20 Angströms. Comme cela est illustré par la figure 8B, chaque barrette semi-conductrice 9 est revêtue, avant son incorporation dans l'agencement 2, d'un film de contact électriquement conducteur, par exemple en or, comportant une partie 13A recouvrant la face 9A et une partie 13B recouvrant la face 9B.

Afin de concentrer l'émission laser à travers les chants 12, les chants opposés 14 desdites barrettes semi-conductrices peuvent être recouverts d'un revêtement réfléchissant 15.

Pour obtenir l'agencement 2, on peut réaliser un empilement alterné de plaquettes 8 et de barrettes 9, de façon que les chants longitudinaux 12 des barrettes semi-conductrices 9, qui forment les faces émettrices des diodes laser, soient coplanaires avec les chants longitudinaux 10 des plaquettes 8 (voir la figure 7) et que chaque barrette 9 ait son film de contact 13A en appui contre le film de soudure 22B d'une plaquette 8 et son film de contact 13B en appui contre le film de soudure 22A d'une autre plaquette 8, puis exercer une pression transversale audit empilement pour presser lesdits films de soudure et lesdits films de contact les uns contre les autres, tout en chauffant l'ensemble (par exemple dans un four à hydrogène) à une température au moins égale à la température de fusion desdits films de soudure. Après refroidissement, les plaquettes 8 et les barrettes 9 sont solidarisées les unes des autres par les films de soudure, qui, par ailleurs, assurent la connexion électrique en série desdites barrettes semi-conductrices 9, en coopération avec lesdits films 11 de matière électriquement conductrice et lesdits films de contact 13A, 13B.

En variante, on peut utiliser, pour la réalisation des films de soudure 22B, un alliage métallique ayant une température de fusion supérieure à celle de l'alliage métallique utilisé pour la réalisation des films de soudure 22A. De la sorte, il est possible, dans un premier temps, de réaliser des sous-ensembles 16 (voir la figure 8E) comportant chacun une barrette 9 et une plaquette 8 sans le film 22A, dont les chants 10 et 12 sont alignés et qui sont solidarisées par le film 22B, puis, dans un deuxième temps, après réalisation du film de soudure 22A sur lesdits sous-ensembles 16, d'empiler lesdits sous-ensembles 16 pour les solidariser par leurs films de soudure 22A. Bien entendu, aussi bien lors de la réalisation des sous-ensembles 16 que lors de leur assemblage, une pression transversale auxdites plaquettes 8 et barrettes 9 est appliquée pendant la fusion des films de colle.

Quel que soit le mode de réalisation mis en oeuvre pour obtenir l'agencement 2, on constate que celui-ci comporte, entre chaque paire de plaques 8 consécutives, un canal longitudinal libre 17, non occupé par la barrette semi-conductrice 9 correspondante.

Comme le montre la figure 7, chaque canal longitudinal 17 est isolé de la barrette semi-conductrice correspondante par un joint 18, par exemple réalisé par injection de silicone ou de résine époxyde. Eventuellement, une plaque de rigidification 19 est fixée sur les chants longitudinaux des plaquettes 8, opposés aux chants longitudinaux 10.

Après réalisation dudit agencement 2, celui-ci est placé et fixé de façon étanche (par exemple par collage) dans le logement 3 du boîtier 1, de manière que ses canaux longitudinaux 17 soient en communication, d'un côté avec le réservoir 4 et, de l'autre, avec le réservoir 5.

Ainsi, quand un fluide de refroidissement, par exemple de l'eau, est amené à circuler dans le boîtier 1 entre la conduite d'amenée 6 et la conduite d'évacuation 7, lesdits canaux longitudinaux 17 sont parcourus en parallèle par ledit fluide qui évacue efficacement la chaleur engendrée par les diodes laser des barrettes semi-conductrices 9 (voir les flèches sur les figures 1 et 2).

Des électrodes 20 et 21 sont reliées électriquement aux films métalliques 11 des plaquettes d'extrémité de l'agencement 2 et permettent de brancher les barrettes de diodes électriquement en série aux bornes d'une alimentation continue ou impulsionnelle. Dans un mode de réalisation du dispositif selon l'invention, on a utilisé des impulsions de courant ayant une intensité de 100 ampères et des durées de l'ordre de 200 à 400 microsecondes.

On voit ainsi que, avec le dispositif de la présente invention, on peut obtenir :
- une grande densité et une bonne homogénéité du rayonnement laser, du fait de la compacité de l'agencement des barrettes de diodes laser 9 ;
- une durée de vie élevée pour ledit dispositif, du fait de l'évacuation efficace de chaleur hors de la zone active des diodes laser ; et
- une automatisation de la fabrication dudit dispositif, permettant d'en réduire les coûts de fabrication.

Les applications du dispositif laser à diodes de la présente invention sont nombreuses et concernent, par exemple, le pompage des lasers à solides, les liaisons pour fibres optiques, le traitement laser des matériaux, la médecine, etc ...

## Revendications

1. Dispositif laser à diodes comportant :
- une pluralité de parois parallèles et espacées (8), en une matière bonne conductrice de la chaleur, qui ont des chants longitudinaux libres (10) au moins approximativement coplanaires et portant des films (11) d'une matière électriquement conductrice qui se prolongent de part et d'autre desdits chants sur les deux faces (8A, 8B) desdites parois ;
- une pluralité de barrettes semi-conductrices (9) incorporant lesdites diodes laser et comprenant chacune une face émettrice (12) par laquelle émettent les diodes laser de la barrette correspondante, lesdites barrettes semi-conductrices (9) étant logées longitudinalement dans les espaces entre lesdites parois (8) et chacune desdites barrettes semi-conductrices (9) étant solidarisée des faces en regard des deux parois (8) entre lesquelles elle est logée, de façon que lesdites barrettes semi-conductrices (9) soient électriquement montées en série par lesdits films de matière électriquement conductrice et que les faces émettrices (12) desdites barrettes semi-conductrices soient au moins approximativement coplanaires avec lesdits chants longitudinaux (10) libres desdites parois ; et
- des moyens de refroidissement à circulation de fluide destinés à refroidir lesdites barrettes de diodes (9),
**caractérisé :**
- **en ce que** lesdites parois parallèles et espacées sont formées par des plaquettes individuelles (8) assemblées les unes aux autres avec interposition desdites barrettes semi-conductrices (9) comme entretoises ;
- **en ce que** lesdites barrettes semi-conductrices (9) n'occupent qu'une partie longitudinale des espaces entre plaquettes (8), dans lesquels elles sont logées ; et
- **en ce que** les parties longitudinales desdits espaces entre plaquettes, non occupées par lesdites barrettes semi-conductrices, servent de canaux de circulation (17) pour ledit fluide de refroidissement.

2. Dispositif selon la revendication 1,
**caractérisé en ce qu'**il comporte, dans les espaces entre plaquettes, des moyens d'étanchéité (18) séparant lesdites parties longitudinales, respectivement occupées et non occupées par lesdites barrettes (9).

3. Dispositif selon l'une des revendications 1 ou 2,
**caractérisé :**
- **en ce qu'**il comporte un boîtier (1) pourvu :
. d'un logement (3) pour l'agencement monopièce (2) des plaquettes individuelles (8) et des barrettes semi-conductrices (9) ;
. des moyens (6) d'amenée dudit fluide de refroidissement dans ledit logement (3) ; et
. des moyens (7) d'évacuation dudit fluide hors dudit logement (3) ; et
- en ce que ledit fluide de refroidissement traverse ledit logement (3) en circulant dans les parties longitudinales (17) desdits espaces entre plaquettes, non occupées par lesdites barrettes.

4. Dispositif selon la revendication 3,
**caractérisé en ce que** ledit boîtier (1) comporte un réservoir d'accumulation de fluide de refroidissement (4 ou 5), d'une part entre lesdits moyens d'amenée (6) et ledit logement (3) et, d'autre part, entre ledit logement (3) et lesdits moyens d'évacuation (7).

5. Procédé pour la réalisation du dispositif laser à diodes spécifié sous l'une des revendications 1 à 4,
**caractérisé en ce que** l'on effectue les opérations suivantes :
- on prépare une pluralité de plaquettes individuelles rectangulaires identiques (8) en une matière bonne conductrice de la chaleur, on polit au moins leurs deux grandes faces (8A, 8B) et un de leurs chants longitudinaux (10) et on recouvre lesdits chants longitudinaux polis (10) et les zones latérales contiguës desdites grandes faces polies (8A, 8B) par des films d'une matière bonne conductrice de l'électricité (11A, 11B, 11C) ;
- on prépare une pluralité de barrettes de diodes semi-conductrices rectangulaires identiques (9), dont un chant longitudinal (12) sert de face émettrice auxdites diodes et dont les deux grandes faces sont recouvertes de films de contact électriquement conducteurs (13A, 13B) ;
- on applique les films de contact desdites barrettes contre les zones latérales (11A, 11B) des films de matière conductrice desdites plaquettes (8), avec interposition de films de solidarisation électriquement conducteurs (22A, 22B) ; et
- on solidarise entre elles lesdites plaquettes (8) et lesdites barrettes (9) par action desdits films de solidarisation, avec application de pression.

6. Procédé selon la revendication 5,
**caractérisé en ce qu'**on recouvre les zones latérales (11A, 11B) des films (11) de matière électriquement conductrice de films de soudure (22A, 22B), électriquement conducteurs.

7. Procédé selon la revendication 6,
**caractérisé :**
- **en ce qu'**on réalise un empilage de toutes lesdites plaquettes (8) et de toutes lesdites barrettes (9), de façon que :
. chaque barrette (9) soit interposée entre deux plaquettes (8) ;
. les chants longitudinaux (10) desdites plaquettes, recouverts d'un film de matière électriquement conductrice (11C) soient au moins approximativement coplanaires ; les faces émettrices (12) desdites barrettes de diode (9) soient au moins approximativement coplanaires avec lesdits chants longitudinaux (10) desdites plaquettes ;
. chaque film de contact (13A, 13B) d'une grande face d'une barrette (9) soit superposé à un film de soudure (22B, 22A) d'une grande face d'une plaquette (8) ; et
- en ce que l'on porte la totalité dudit empilage à une température correspondant à la température de fusion desdits films de soudure (22A, 22B), tout en soumettant ledit empilage à une pression transversale auxdites plaquettes et barrettes, après quoi on laisse refroidir ledit empilage.

8. Procédé selon la revendication 6,
**caractérisé :**
- **en ce que**, lors de la préparation desdites plaquettes (8), on recouvre l'un (11B) desdits films de matière conductrice latéraux de chaque plaquette (8), d'un film (22B) d'une première soudure électriquement conductrice ;
- **en ce qu'**on forme une pluralité de sous-ensembles (16), dont chacun d'eux comporte une plaquette (8) et une barrette (9), en superposant à chaque fois une plaquette et une barrette de façon que le film de soudure de la plaquette soit superposé à un film de contact de la barrette et que le chant longitudinal (10) de ladite plaquette soit au moins approximativement coplanaire avec la face émettrice (12) de la barrette, puis en portant chaque sous-ensemble (16) à une température correspondant à la température de fusion de ladite première soudure, tout en le soumettant à une pression transversale à ladite plaquette et à ladite barrette, après quoi on laisse refroidir ledit sous-ensemble ;
- **en ce que**, dans chaque sous-ensemble (16), on recouvre l'autre (11A) desdits films latéraux de matière conductrice de la plaquette (8) correspondante, d'un film (22A) d'une seconde soudure électriquement conductrice, ayant une température de fusion inférieure à celle de ladite première soudure ;
- **en ce qu'**on forme un empilage desdits sous-ensembles (16), en les superposant, à chaque fois, de façon que l'autre film de contact (13B) de la barrette d'un sous-ensemble soit appliqué contre le film de ladite seconde soudure (22A) de la plaquette d'un autre sous-ensemble (16) et que les chants longitudinaux de toutes les plaquettes soient au moins approximativement coplanaires entre eux et avec les faces émettrices desdites barrettes ; et
- **en ce que** l'on porte ledit empilage de sous-ensembles (16) à une température correspondant à la température de fusion de ladite seconde soudure, tout en soumettant ledit empilage à une pression transversale auxdites plaquettes et barrettes, après quoi on laisse refroidir ledit empilage de sous-ensembles.

## Patentansprüche

1. Diodenlaseranordnung, welche aufweist:
- eine Vielzahl von parallelen und mit Abstand voneinander angeordneten Wänden (8) aus einem gut wärmeleitenden Material, die wenigstens annähernd koplanare, freie, in Längsrichtung verlaufende Kanten (10) aufweisen und Filme (11) aus einem elektrisch leitfähigen Material tragen, die sich beiderseits der Kanten über die beiden Flächen (8A, 8B) der Wände ausdehnen;
- eine Vielzahl von Halbleiterstegen (9), die die Laserdioden aufnehmen und jeweils eine Sendefläche (12) umfassen, über die die Laserdioden des entsprechenden Stegs senden, wobei die Halbleiterstege (9) in Längsrichtung in den Räumen zwischen den Wänden (8) untergebracht sind und jeder der Halbleitestege (9) mit Flächen fest verbunden ist, die den beiden Wänden, zwischen welchen er untergebracht ist, gegenüberstehen, so dass die Halbleiterstege (9) mit den Filmen aus elektrisch leitfähigem Material elektrisch in Reihe geschaltet sind und die Sendeflächen (12) der Halbleiterstege wenigstens annähernd mit den freien, in Längsrichtung verlaufenden Kanten (10) der Wände koplanar sind; und
- Kühlungsmittel mit Fluidumlauf, die dafür vorgesehen sind die Diodenstege (9) zu kühlen,
**dadurch gekennzeichnet,**
- **dass** die parallelen und mit Abstand voneinander angeordneten Wände von einzelnen Platten (8) gebildet werden, die zusammengesetzt sind, wobei die Halbleiterstege (9) als Zwischenstücke dazwischen angeordnet sind;
- **dass** die Halbleiterstege (9) nur einen in Längsrichtung verlaufenden Teil der Räume zwischen den Platten (8) einnehmen, in denen sie untergebracht sind; und
- **dass** die in Längsrichtung verlaufenden Teile der Räume zwischen den Platten, die nicht von den Halbleiterstegen eingenommen sind, als Umlaufkanäle (17) für das Kühlfluid dienen.

2. Anordnung nach Anspruch 1, **dadurch gekennzeichnet, dass** sie in den Räumen zwischen den Platten Dichtungsmittel (18) aufweist, die die von den Stegen (9) eingenommenen bzw. nicht eingenommenen, in Längsrichtung verlaufenden Teile trennen.

3. Anordnung nach einem der Ansprüche 1 oder 2,
**dadurch gekennzeichnet,**
- **dass** sie ein Gehäuse (1) aufweist, das mit
. einer Aufnahme (3) für die einstückige Anordnung (2) der einzelnen Platten (8) und Halbleiterstege (9);
. Zufuhrmitteln (6) für das Kühlfluid in der Aufnahme (3); und
. Ablassmitteln (7) für das Fluid außerhalb der Aufnahme (3) versehen ist; und
- dass das Kühlfluid beim Umlaufen in den in Längsrichtung verlaufenden Teilen (17) der Räume zwischen Platten, die von den Stegen nicht eingenommen werden, durch die Aufnahme (3) strömt.

4. Anordnung nach Anspruch 3, **dadurch gekennzeichnet, dass** das Gehäuse (1) ein Sammelreservoir (4 oder 5) für das Kühlfluid einerseits zwischen den Zufuhrmitteln (6) und der Aufnahme (3) und andererseits zwischen der Aufnahme (3) und den Ablassmitteln (7) aufweist.

5. Verfahren zur Herstellung der in den Ansprüchen 1 bis 4 spezifizierten Diodenlaseranordnung,
**dadurch gekennzeichnet, dass** die folgenden Vorgänge ausgeführt werden:
- es wird eine Vielzahl von gleichen, rechteckigen, einzelnen Platten (8) aus einem gut wärmeleitenden Material hergestellt, es werden wenigstens ihre beiden großen Flächen (8A, 8B) und eine ihrer in Längsrichtung verlaufenden Kanten (10) poliert und es werden die polierten in Längsrichtung verlaufenden Kanten (10) und die angrenzenden seitlichen Bereiche der polierten großen Flächen (8A, 8B) mit Filmen (11A, 11B, 11C) aus einem gut die Elektrizität leitenden Material überzogen;
- es wird eine Vielzahl von gleichen, rechteckigen Halbleiterdiodenstegen (9) hergestellt, deren eine in Längsrichtung verlaufende Kante (12) als Sendefläche für die Dioden dient und deren beiden großen Flächen mit elektrisch leitfähigen Kontaktfilmen (13A, 13B) überzogen sind;
- es werden die Kontaktfilme der Stege gegen die seitlichen Bereiche (11A, 11B) der Filme aus leitfähigem Material der Platten (8) gedrückt, wobei elektrisch leitende Verbindungsfilme (22A, 22B) dazwischen angeordnet werden; und
- es werden die Platten (8) und die Stege (9) durch die Wirkung der Verbindungsfilme unter Anwendung von Druck miteinander verbunden.

6. Verfahren nach Anspruch 5, **dadurch gekennzeichnet, dass** die seitlichen Bereiche (11A, 11B) der Filme (11) aus elektrisch leitfähigem Material mit elektrisch leitfähigen Lotfilmen (22A, 22B) bedeckt werden.

7. Verfahren nach Anspruch 6,
**dadurch gekennzeichnet,**
- **dass** ein Stapel von allen Platten (8) und allen Stegen (9) hergestellt wird, so dass:
. jeder Steg (9) zwischen zwei Platten (8) angeordnet ist;
. die in Längsrichtung verlaufenden Kanten (10) der Platten, die mit einem Film (11C) aus elektrisch leitfähigem Material überzogen sind, wenigstens annähernd koplanar sind;
. die Sendeflächen (12) der Diodenstege (9) mit den in Längsrichtung verlaufenden Kanten (10) der Platten wenigstens annähernd koplanar sind;
. jeder Kontaktfilm (13A, 13B) mit einer großen Fläche eines Stegs (9) über einem Lotfilm (22B, 22A) mit einer großen Fläche einer Platte (8) angeordnet ist; und
- **dass** die Gesamtheit des Stapels auf eine Temperatur gebracht wird, die der Schmelztemperatur der Lotfilme (22A, 22B) entspricht, wobei der Stapel einem Druck quer zu den Platten und Stegen ausgesetzt wird, wonach sich der Stapel abkühlen kann.

8. Verfahren nach Anspruch 6,
**dadurch gekennzeichnet,**
- **dass** bei der Herstellung der Platten (8) einer (11B) der beiden seitlichen Filme aus leitendem Material jeder Platte (8) mit einem Film (22B) eines ersten, elektrisch leitfähigen Lots bedeckt wird;
- **dass** eine Vielzahl von Untereinheiten (16) gebildet wird, wobei jede von ihnen eine Platte (8) und einen Steg (9) aufweist, indem jeweils eine Platte und ein Steg so übereinandergelegt wird, dass der Lotfilm der Platte über einen Kontaktfilm des Stegs gelegt ist und dass die in Längsrichtung verlaufende Kante (10) der Platte mit der Sendefläche (12) des Stegs wenigstens annähernd koplanar ist, indem dann jede Untereinheit (16) auf eine Temperatur gebracht wird, die der Schmelztemperatur des ersten Lots entspricht, wobei sie einem Druck quer zur Platte und zum Steg ausgesetzt wird, wonach sich die Untereinheit abkühlen kann;
- **dass** bei jeder Untereinheit (16) der andere (11A) der seitlichen Filme aus leitendem Material der entsprechenden Platte (8) mit einem Film (22A) eines zweiten, elektrisch leitfähigen Lots überzogen wird, das eine Schmelztemperatur aufweist, die geringer als diejenige des ersten Lots ist;
- **dass** aus diesen Untereinheiten (16) ein Stapel gebildet wird, indem sie jeweils so übereinandergelegt werden, dass der andere Kontaktfilm (13B) des Stegs einer Untereinheit gegen den Film aus dem zweiten Lot (22A) der Platte einer anderen Untereinheit (16) gedrückt wird und dass die in Längsrichtung verlaufenden Kanten aller Platten wenigstens untereinander und mit den Sendeflächen der Stege koplanar sind; und
- **dass** der Stapel aus Untereinheiten (16) auf eine Temperatur gebracht wird, die der Schmelztemperatur des zweiten Lots entspricht, wobei der Stapel einem Druck quer zu den Platten und Stegen ausgesetzt wird, wonach sich der Stapel aus Untereinheiten abkühlen kann.

## Claims

1. Laser diode device having:
- a plurality of parallel and spaced-apart walls (8), made of a material which is a good heat conductor, which have at least approximately coplanar free longitudinal edges (10) bearing films (11) of an electrically conductive material which extend on each side of said edges on both faces (8A, 8B) of said walls;
- a plurality of semiconductor strips (9) incorporating said laser diodes, each strip comprising an emitting surface (12) via which the laser diodes of the corresponding strip emit, said semiconductor strips (9) being housed longitudinally in the spaces between said walls (8) and each of said semiconductor strips (9) being fastened to the opposite faces of the two walls (8) between which it is housed, so that said semiconductor strips (9) are electrically connected in series by said films of electrically conductive material and so that the emitting surfaces (12) of said semiconductor strips are at least approximately coplanar with said free longitudinal edges (10) of said walls; and
- fluid-circulation cooling means intended for cooling said diode strips (9),
**characterized:**
- **in that** said parallel and spaced-apart walls are formed by individual plates (8) joined together, with said semiconductor strips (9) interposed between them as spacers;
- **in that** said semiconductor strips (9) occupy only one longitudinal part of the spaces between plates (8), in which spaces they are housed; and
- **in that** those longitudinal parts of said spaces between plates which are not occupied by said semiconductor strips serve as circulation channels (17) for said cooling fluid.

2. Device according to Claim 1, **characterized in that** it includes, in the spaces between plates, sealing means (18) separating respectively said longitudinal parts occupied by said strips (9) from those not occupied by the latter.

3. Device according to either of Claims 1 and 2,
**characterized:**
- **in that** it includes a package (1) provided:
. with a housing (3) for the one-piece assembly (2) comprising the individual plates (8) and the semiconductor strips (9);
. with means (6) for the intake of said cooling fluid into said housing (3); and
. with means (7) for the discharge of said fluid out of said housing (3); and
- **in that** said cooling fluid passes through said housing (3) by flowing through the longitudinal parts (17) of those said spaces between plates which are not occupied by said strips.

4. Device according to Claim 3,
**characterized in that** said package (1) includes a cooling-fluid accumulation reservoir (4 or 5), on the one hand, between said intake means (6) and said housing (3) and, on the other hand, between said housing (3) and said discharge means (7).

5. Process for producing the laser diode device specified under one of Claims 1 to 4,
**characterized in that** the following operations are carried out:
- a plurality of identical rectangular individual plates (8) made of a material which is a good heat conductor are prepared, at least their two large faces (8A, 8B) and one of their longitudinal edges (10) are polished and said polished longitudinal edges (10) and the lateral regions contiguous with said polished large faces (8A, 8B) are covered with films (11A, 11B, 11C) of a material which is a good electrical conductor;
- a plurality of identical rectangular semiconductor diode strips (9), one longitudinal edge (12) of which serves as an emitting surface to said diodes and the two large faces of which are covered with electrically conductive contact films (13A, 13B), are prepared;
- the contact films of said strips are applied against the lateral regions (11A, 11B) of the films of conductive material of said plates (8), between which are interposed electrically conductive fastening films (22A, 22B); and
- said plates (8) and said strips (9) are fastened together through the action of said fastening films, with application of pressure.

6. Process according to Claim 5,
**characterized in that** the lateral regions (11A, 11B) of the films (11) of electrically conductive material are covered with electrically conductive solder films (22A, 22B).

7. Process according to Claim 6,
**characterized:**
- **in that** a stack of all said plates (8) and all said strips (9) is produced so that:
· each strip (9) is interposed between two plates (8);
· those longitudinal edges (10) of said plates which are covered with a film (11C) of electrically conductive material are at least approximately coplanar;
· the emitting surfaces (12) of said diode strips (9) are at least approximately coplanar with said longitudinal edges (10) of said plates; each contact film (13A, 13B) of a large face of a strip (9) is superposed with a solder film (22B, 22A) of a large face of a plate (8); and
- **in that** the entire said stack is raised to a temperature corresponding to the melting point of said solder films (22A, 22B), while at the same time subjecting said stack to pressure transversely with respect to said plates and strips, after which said stack is left to cool.

8. Process according to Claim 6,
**characterized:**
- **in that**, during the preparation of said plates (8), one (11B) of said lateral films of conductive material of each plate (8) is covered with a film (22B) of a first electrically conductive solder;
- **in that** a plurality of subassemblies (16), each of which comprises a plate (8) and a strip (9), are formed by superposing, each time, a plate and a strip so that the solder film of the plate is superposed with a contact film of the strip and so that the longitudinal edge (10) of said plate is at least approximately coplanar with the emitting surface (12) of the strip, then by raising each subassembly (16) to a temperature corresponding to the melting point of said first solder while at the same time subjecting it to pressure transversely with respect to said plate and to said strip, after which said subassembly is left to cool;
- **in that**, in each subassembly (16), the other (11A) of said lateral films of conductive material of the corresponding plate (8) is covered with a film (22A) of a second electrically conductive solder having a melting point below that of said first solder;
- **in that** a stack of said subassemblies (16) is formed by superposing them, each time so that the other contact film (13B) of the strip of one subassembly is applied against the film (22A) of said second solder of the plate of another subassembly (16) and so that the longitudinal edges of all the plates are at least approximately coplanar with each other and with the emitting surfaces of said strips; and
- **in that** said stack of subassemblies (16) is raised to a temperature corresponding to the melting point of said second solder, while at the same time subjecting said stack to pressure transversely with respect to said plates and strips, after which said stack of subassemblies is left to cool.
